# EUROPEAN PATENT APPLICATION

(11) **EP 4 694 587 A1**
(43) Date of publication of application: **11.02.2026**
(21) Application number: 24193289.6
(22) Date of filing: 07.08.2024
(51) Int. Cl.: H05K 3/30, H05K 3/34

(54) **A SEMICONDUCTOR MODULE AND A METHOD FOR COUPLING A SEMICONDUCTOR MODULE WITH A PRINTED CIRCUIT BOARD**

(71) Applicant: Infineon Technologies AG, 85579 Neubiberg (DE)
(72) Inventor: AL KASSOU, Amir, 41542 Dormagen (DE); FLECHSIG, Andre Dominik, 59494 Soest (DE); SCHWARZER, Ulrich, 59581 Warstein (Belecke) (DE)
(74) Representative: Infineon Patent Department

(57) **Abstract**

The semiconductor module comprises a substrate comprising a first surface, a first contact pin and a second pin. A respective first end of the first contact pin and the second contact pin is mounted over the first surface of the substrate. Further, a respective first section of the first contact pin and the second contact pin is configured to be connected to a printed circuit board, PCB. The first section of the first contact pin is insertable to the PCB with a first press-in force and the first section of the second contact pin is insertable to the PCB with a second press-in force. The first press-in force is different than the second press-in force. The first contact pin is provided in a central region of the substrate and the second contact pin is provided in a peripheral region of the substrate.

## Description

### TECHNICAL FIELD

The present disclosure relates to a semiconductor module, in particular to a semiconductor module with press-fit contact pins and a method for coupling the semiconductor module with a printed circuit board.

### BACKGROUND

Semiconductor modules often have a substrate arranged in a housing. A plurality of semiconductor dies (e.g., two IGBTs/MOSFETs in a half-bridge configuration) as well as other elements such as bond wires and contact pins etc. may be mounted on a first side of the substrate by soldering, sintering or welding. The second side of the substrate may be mounted to a heat sink.

The substrate is heated and cooled down during the mounting process. Different thermal expansion coefficients of the various materials may lead to deformations of the substrate. These deformations may lead to uneven distribution of heat when the semiconductor module is mounted to the heat sink.

The present disclosure provides a solution to address the above described as well as further issues.

### SUMMARY

The disclosure relates inter alia to a method for mounting a semiconductor module on a printed circuit board, PCB. The method comprising:
providing a semiconductor module comprising:
   a substrate having a first surface,
   a first contact pin having a first end and an opposing second end,
   a second contact pin having a first end and an opposing second end,
   wherein the respective first end of the first contact pin and the second contact pin is mounted over the first surface of the substrate,
pressing the first contact pin and the second contact pin into respective through-holes of the PCB by applying a force (F) on the semiconductor module,
inserting a first section of the first contact pin into the respective through-hole of the PCB with a first press-in force,
inserting a first section of the second contact pin into the respective through-hole of the PCB with a second press-in force,
wherein the first press-in force is different than the second press-in force, and
wherein the first contact pin is provided in a central region of the substrate and the second contact pin is provided in a peripheral region of the substrate.

A semiconductor module according to the present disclosure comprises a substrate comprising a first surface, a first contact pin and a second pin. A respective first end of the first contact pin and the second contact pin is mounted over the first surface of the substrate. Further, a respective first section of the first contact pin and the second contact pin is configured to be connected to a printed circuit board, PCB. The first section of the first contact pin is insertable to the PCB with a first press-in force and the first section of the second contact pin is insertable to the PCB with a second press-in force different than the first press-in force. The first contact pin is provided in a central region of the substrate and the second contact pin is provided in a peripheral region of the substrate.

Another semiconductor module according to the present disclosure comprises a substrate having a first surface. A first contact pin has a first end and a first section. A housing partially encloses the substrate and the first contact pin. The first end of the first contact pin is mounted over the first surface of the substrate. The first section of the first contact pin is configured to be connected to a printed circuit board, PCB. The first contact pin comprises a stopper outside of the housing. A width of the stopper is equal to or larger than a width of the first section of the first contact pin. The width of the stopper and the width of the first section of the first contact pin are measured in a plane parallel to the first surface of the substrate.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Figures 1A to 1C show various steps of a method of mounting a semiconductor module onto a printed circuit board (PCB).
Figures 2A-2B show steps of mounting a heat sink on a semiconductor module after inserting contact pins of the semiconductor module into a printed circuit board.
Figure 3 shows a further example of a semiconductor module with a convex outer surface of a substrate after mounting to a PCB due to different lengths of the contact pins.
Figures 4A-4B show a further example of a semiconductor module with a convex outer surface of the substrate after mounting to a PCB due to a contact pin comprising a stopper.
Figures 5A-5B show a further example of a semiconductor module before and after mounting to a PCB respectively due to contact pins comprising stopper elements.
Figure 6 shows a top view of a semiconductor module with a central region and a peripheral region.

### DETAILED DESCRIPTION

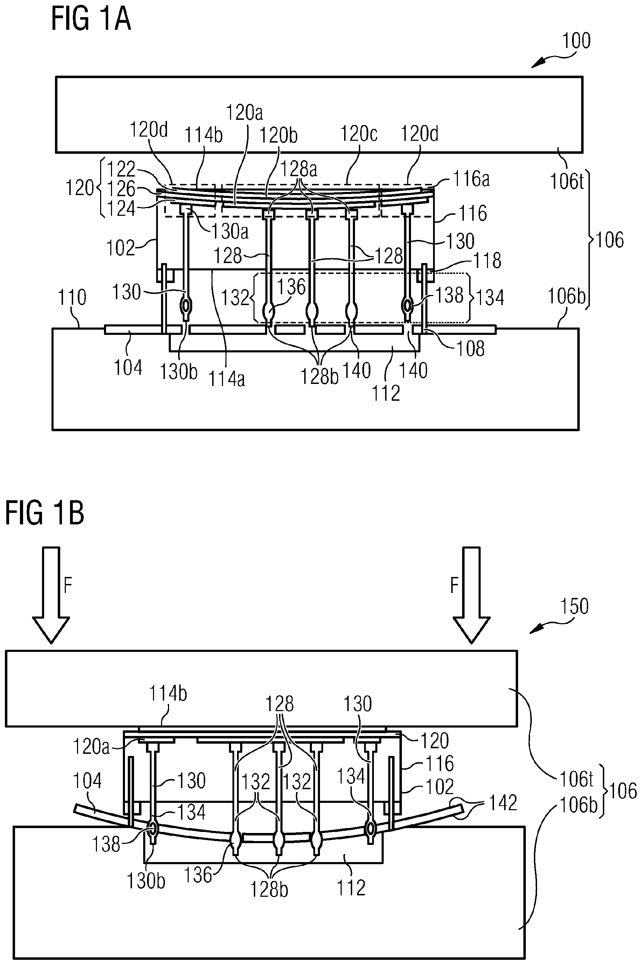

Referring to Figures 1A to 1C, various steps of a method of mounting a semiconductor module 102 onto a printed circuit board 104 (PCB) are depicted. Figure 1A shows the step of providing 100 the semiconductor module 102 wherein the semiconductor module is arranged in a pressing tool 106 together with the PCB 104.

The semiconductor module 102 has a substrate 120 at least partially enclosed inside a housing 116. The substrate 120 has an outer metal layer 122 and an inner metal layer 124 disposed on opposing sides of a dielectric sheet 126. The inner metal layer 124 may be structured i.e., the inner metal layer 124 may not be a continuous layer but includes recesses between different sections of the inner metal layer 124. The metal layers 120, 122 can comprise or be plated with Cu, Ni, Ag, Au, Pd, Pt, NiV, NiP, NiNiP, NiP/Pd, Ni/Au, NiP/Pd/Au, or NiP/Pd/AuAg, for example. An outermost surface of the inner metal layer 124 facing a first outer surface 114a of the semiconductor module 102 forms a first surface 120a of the substrate 120. An outermost surface of the outer metal layer 122 in a direction parallel to the first surface 120a of the substrate 120 forms a second surface 120b of the substrate 120. The first surface 120a of the substrate is enclosed inside the housing 116 and the second surface 120b of the substrate is at least partially exposed from a first side 116a of the housing 116. The second surface 120b of the substrate 120 and the first side 116a of the housing 116 form a second outer surface 114b of the semiconductor module 102. The first outer surface 114a and the second outer surface 114b of the semiconductor module 102 are opposite to each other. The substrate may have a thickness in a range of 0.4 mm to 2 mm measured between the first surface 120a and the second surface 120b of the substrate 120. The substrate 120 may be a direct copper bonded substrate or an active metal brazed substrate.

The semiconductor module 102 has a first contact pin 128 and a second contact pin 130 arranged over the first surface 120a of the substrate 120. An electrically conductive joint is formed between each contact pin 128, 130 and the first surface 120a of the substrate 120, in order to electrically and mechanically couple each contact pin 128, 130 to the substrate 120. The electrically conductive joint may be formed by a solder, an electrically conductive adhesive, a sintered metal powder, e.g. a sintered powder, or by a welding beam.

Further, the semiconductor module 102 may have semiconductor dies arranged on the first surface 120a of the substrate 120 (not shown) via an electrically conducting layer, in order to electrically and mechanically couple the substrate 120 to the semiconductor dies. The electrically conductive layer may be formed by a solder or a sinter powder. The semiconductor dies may be arranged to form a half-bridge circuit or a full-bridge circuit.

The electrically conductive layer and the electrically conductive joint are heated and cooled down in order to fix the respective components (semiconductor dies and the contact pins) on the substrate 120. The metal layers 122, 124 of the substrate 120 are made of different material than the electrically conductive joint and the electrically conductive layer and therefore have a different coefficient of thermal expansion than the electrically conductive joint and the electrically conductive layer. The metal layer 122, 124 of the substrate 120 contract and expand at different rates during heating and cooling down as compared to the electrically conductive joint and the electrically conductive layer. This leads to an inward bend in the substrate 120. The inward bend implies that a central region 120c of the substrate 120 bends stronger toward the first outer surface 114a of the semiconductor module 102 than a peripheral region 120d of the substrate 120. Thus, the inward bend bows the substrate 120 typically in a concave shape with respect to the first outer surface 114a of the semiconductor module 102 as shown in Figure 1A. When the second surface 120b of the substrate 120 is mounted on a heat sink (not shown), a cavity is formed between the inward bend and the heat sink. The inward bend may have a depth of up to several 10 µm. The depth of the inward bend is measured between the second surface 120b of the substrate 120 and a line joining the diagonally opposite edges of the substrate 120 in a direction vertical to the first outer surface 114a of the semiconductor module 102.

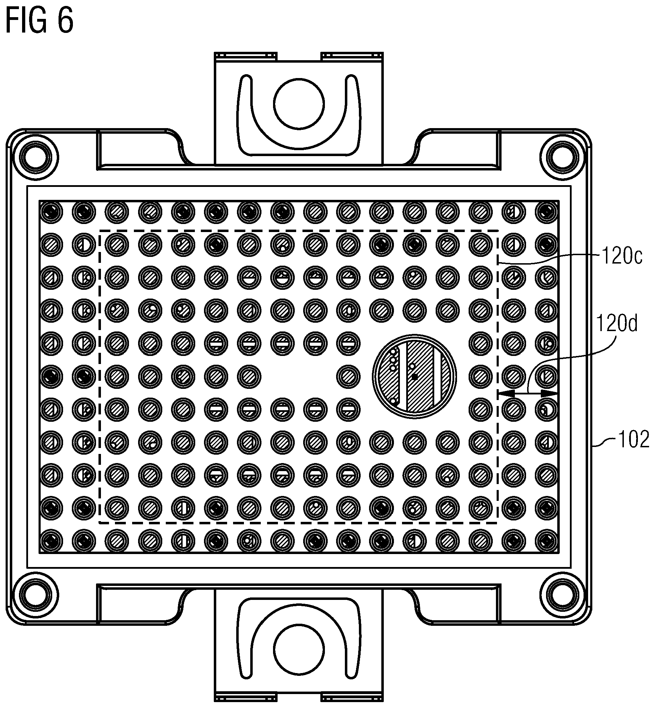

The central region 120c and a peripheral region 120d extend in the direction parallel to the first outer surface 114a of the semiconductor module 102. The peripheral region 120d is laterally located outside of the central region 120c between the central region 120c and an edge of the substrate 120 as shown in a top view of the semiconductor module 102 in Figure 6. The central region 120c of the substrate 120 may occupy an area up to 30% or 40% or 50% or 60% or 70% of an area of the first surface 120a of the substrate 120.

The first contact pin 128 is provided in the central region 120c and the second contact pin 130 is provided in the peripheral region 120d of the substrate 120 as shown in Figure 1A. The second contact pin 130 is closer to the edge of the substrate 120 than the first contact pin 128 in at least one common lateral direction. Both contact pins 128, 130 have a first end 128a, 130a and an opposing second end 128b 130b. The first ends 128a, 130a are electrically and mechanically coupled to the first surface 120a of the substrate 120 and are enclosed inside the housing 116. The second end 128b, 130b of each contact pin 128, 130 protrudes from the first outer surface 114a of the semiconductor module 102. The semiconductor module 102 may have more than one first contact pin 128 and more than one second contact pin 130 as shown in Figure 1A.

In some examples, the first end 128a, 130a of each contact pin 128, 130 is electrically and mechanically coupled to the first surface 120a of the substrate 120 by electrically conductive elements, e.g. sleeves. The electrically conductive elements are soldered, sintered or welded on the first surface 120a of the substrate 120. The respective first end 128a, 130a of the first contact pin 128 and the second contact pin 130 is inserted inside the electrically conductive sleeve providing a press-fit connection.

In some examples, the first contact pin 128 and the second contact pin 130 may be mounted on separate isolated regions of the first surface 120a of the substrate 120. The isolated regions of the first surface 120a of the substrate 120 may be electrically isolated from the rest of the first surface 120a of the substrate 120 and thus do not conduct an electrical current. Therefore, the first contact pin 128 and the second contact pin 130 may also carry no electrical current.

A respective first section 132, 134 of each contact pin 128, 130 that is closer to the second end 128b, 130b than to the first end 128a, 130a is configured to be in physical contact with a PCB 104 after mounting to the PCB. A first locking feature 136 may be provided at the first section 132 of first contact pin 128. Similarly, a second locking feature 138 may be provided at the first section 134 of second contact pin 130. The locking features 136, 138 are insertable into the PCB 104 and are configured to lock the first section 132, 134 of the respective contact pin 128, 130 into the PCB 104. The locking features 136, 138 may be different from each other. In the example depicted in Figure 1A, the first locking feature 136 comprises a simple solid bulge. The second locking feature 138 on the other hand comprises a hole or a recess inside the bulge.

Therefore, the second locking feature 138 deforms easier when pressed into the PCB 104 as compared to the first locking feature 136. Hence the second contact pin 130 in this example requires a lower press-in force than the first contact pin 128 to be inserted into the PCB 104.

The pressing tool 106 used to press the semiconductor module 102 into the PCB 104 has a top part 106t, a bottom part 106b and guiding pins 108. The top part 106t of the pressing tool 106 is aligned above the bottom part 106b of the pressing tool 106. The guiding pins 108 protrude from a surface 110 of the bottom part 106t of the pressing tool 106. The PCB 104 is arranged on the surface 110 of the bottom part 106t of the pressing tool 106 by inserting the guiding pins108 into the through-holes of the PCB 104. In this example, a central part of the PCB 104 overlaps with a recess 112 in the surface 110 of the bottom part 106t of the pressing tool 106. However, the recess 112 may be optional.

The semiconductor module 102 is arranged above the PCB 104 at the central part of the PCB 104 by inserting the dome structures 118 of the housing 116 into the guiding pins 108. The dome structures 118 of the housing 116 protrude from the first outer surface 114a of the semiconductor module 102 and are hollow. The second outer surface 114b of the semiconductor module 102 faces the top part 106t of the pressing tool 106.

While pressing 150 the semiconductor module 102 onto the PCB 104 as shown in Figure 1B, a force F is applied on the second outer surface 114b of the semiconductor module 102 using the top part 106t of the pressing tool 106. Pressing 150 the semiconductor module 102 into the PCB 104 implies inserting the second end 128b, 130b of each contact pin 128, 130 into the respective through-hole 140 of the PCB 104 and physically contacting the first section 132, 134 of each pin 128,130 to the PCB 104. The through-holes 140 of the PCB 104 may have a width of 0.99 mm to 1.09 mm measured in the direction parallel to the first outer surface 114a of the semiconductor module 102. The through-holes of the PCB 104 may have a metallized wall of thickness 30 um to 50 um. The width of the through-hole 140 in the PCB 104 is less than a width of the respective locking feature 136, 138 of the first contact pin 128 and the second contact pin 130. The width of the locking features is measured in a direction parallel to the first outer surface 114a of the semiconductor module 102.

The first section 132 of the first contact pin 128 is inserted into the PCB 104 with a first press-in force and the first section 134 of the second contact pin 130 is inserted into the PCB 104 with a second press-in force. The first press-in force is different than the second press-in force. In particular, the first press-in force may be larger than the second press-in force. This is achieved by different material and shapes of the locking features 126, 138 of each contact pin 128, 130 as explained herein below. As an arbitrary example, the first press-in force may be between 80 N to 100 N and the second press-in force may be below 60 N. The press in forces may depend on the concrete application and PCB properties.

The force F applied by the pressing tool 106 to the second outer surface 114b of the semiconductor module 102 is increased gradually. In an initial phase of the pressing, the force F is smaller than the first press-in force and the second press-in force. Therefore, the first section 132, 134 of each pin 128,130 cannot penetrate the PCB 104 and the pins 128, 130 push the substrate 120 against the upper part 106t of the pressing tool 106. Consequently, the substrate 120 becomes flat. In a further phase of the pressing, the force F is increased and exceeds the second press-in force needed to insert the first section 134 of the second pin 130 into the PCB 104. The second locking feature 138 adapts itself to slide inside the respective through-hole 140 of the PCB 104. Since the force F is still below the required press-in force needed to press the first contact pin 128 into the PCB, the PCB 104 is deformed and bent inside the recess 112 of the bottom part 106t of the pressing tool 106. Upon further pressing the pressing tool parts to one another, the force F further increases and now also exceeds the first press-in force needed to insert the first section 132 of the first pin 128 into the PCB. The first locking feature 136 adapts itself to slide inside the respective through-hole 140 of the PCB 104. At the same time the second contact pin 130 slides further into the respective through-hole 140 of the PCB 104. Accordingly, a depth of the second contact pin 130 penetrating the PCB 104 is slightly larger than a depth of the first contact pin 128 penetrating the PCB 104. The depth of each contact pin 128, 130 penetrating the PCB 104 is measured between the respective second end 128b, 130b of the contact pin 128, 130 and a surface 142 of PCB 104 in a direction vertical to the first outer surface 114a of the semiconductor module 102. The surface 142 of the PCB 104 faces the first outer surface 114a of the semiconductor module 102.

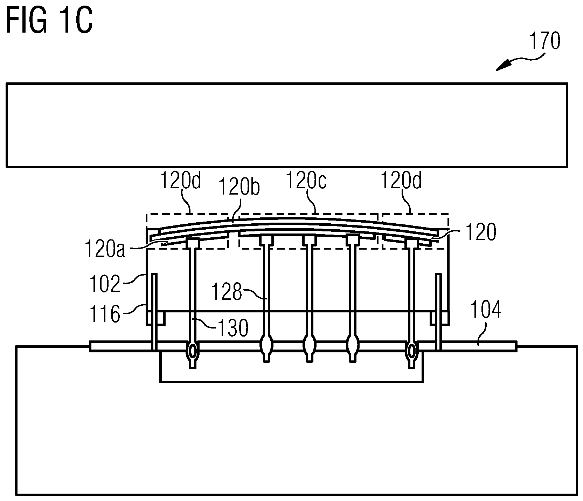

Figure 1C shows the semiconductor module 102 and the PCB 104 upon lifting 170 the upper part 106t of the pressing tool 106, i.e. after releasing force F. As described herein above, both contact pins 128, 130 penetrate to slightly different depths into the respective through-hole 140 of the PCB 104. Accordingly, the first contact pin 128 wants to establish a first height between the PCB 104 and the substrate 120 in the central region 120c after lifting 170. Thus, the first contact pin 128 exerts a first pulling force between the PCB 104 and the substrate 120. Similarly, the second contact pin 130 wants to establish a second height between the PCB 104 and the substrate 120 in the peripheral region 120d after lifting 170. Thus, the second contact pin 130 exerts a second pulling force between the PCB 104 and the substrate 120. The first height is smaller than the second height and therefore the first pulling force is different from the second pulling force.

A large amount of the PCB 104 is made of an elastic material, e.g. a glass-reinforced epoxy laminate material such as but not limited to FR-4. The PCB 104 may have a thickness greater than the thickness of the substrate and a glass transition temperature Tg in a range of 115°C to 200°C. The PCB 104 may thus be stiffer than the substrate 120. Thus, after lifting 170 the upper part 106t of the pressing tool 106, the PCB 104 would return to its original shape. The difference of the two pulling forces exerted by the first 128 and second contact pins 130 is compensated by creating an outward bend of the substrate 120 compared to the initial state. The outward bend implies that the central region 120c of the substrate 120 bends away from the first outer surface 114a of the semiconductor module 102. Thus, the outward bend bows the substrate 120 in a convex shape with respect to the first outer surface 114a of the semiconductor module 102 as shown in Figure 1C. The outward bend may have a height of up to 180 µm measured between the second surface 120b of the substrate 120 in the central region 120c and the line joining the diagonally opposite edges of the substrate 120 in the direction vertical to the first outer surface 114a of the semiconductor module 102.

The contact pins 128, 130 shown in Figures 1A-1C have the same length. The length of each contact pin 128, 130 is measured between their respective first end 128a 130a and second end 128b 130b. In some examples, the first contact pin 128 may be longer than the second contact pin 130.

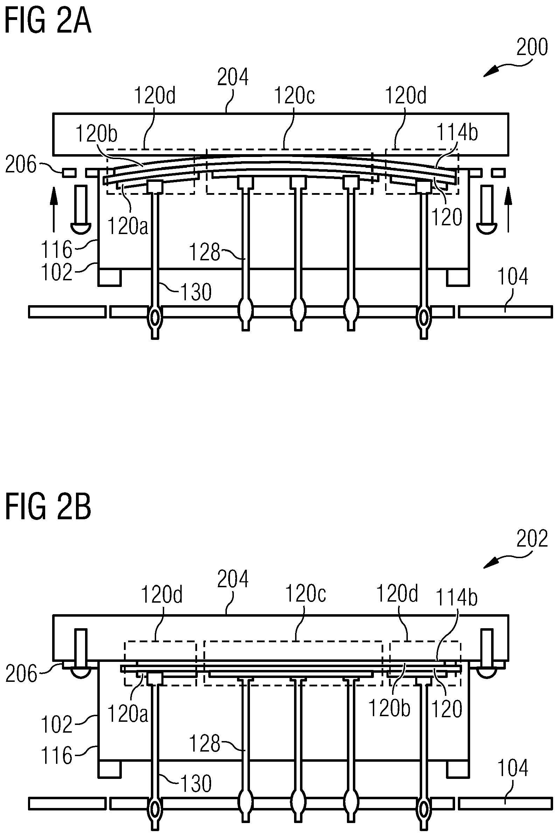

Figures 2A-2B show the semiconductor module 102 before and after mounting a heat sink onto the semiconductor module 102 respectively. As described herein, after inserting contact pins 128, 130 of the semiconductor module 102 into the PCB 104, the substrate 120 has an outward bend in the central region 120c of the substrate 120. A heat sink 204 is arranged 200 on the second outer surface 114b of the semiconductor module 102. Due to the outward bend in the central region 120c of the substrate 120, the central region 120c of the substrate 120 is in contact with the heat sink 204 as shown in Figure 2A. However, there is a gap between the peripheral region 120d of the substrate 120 and the heat sink 204. The heat sink 204 is mounted, e.g. clamped, sintered or screwed onto the semiconductor module 102. The pressure exerted onto the semiconductor module 102 during mounting of the heat sink 204 is mainly applied to the edges of the second outer surface 114b of the semiconductor module 102. As a result, the peripheral region 120d of the substrate 120 moves toward the heat sink 204 such that the substrate 120 becomes substantially flat.

As an example, screwing 202 the heat sink 204 onto the semiconductor module 102 is depicted in Figures 2A-2B. The housing 116 further has a connection portion 206 protruding from a side of the housing 116 adjacent to the second outer surface 114b of the semiconductor module 102. The connection portion 206 may comprise a hole. When the heat sink 204 is screwed onto the semiconductor module 102 through the hole of the connection portion 206, the connection portion 206 is pressed toward the heat sink 204. The peripheral region 120d of the substrate 120 moves towards the heat sink 204, bending the inner central portion towards the inside such that the substrate 120 becomes flat as shown in Figure 2B. As a result, a uniform connection between the semiconductor module 102 and the heat sink 204 may be established. This may increase the efficiency of heat transfer between the substrate 120 and the heat sink 204 as compared to the substrate 120 comprising an outward bend or inward bend. A thermal interface material (not shown) may be arranged between the substrate 120 and the heat sink.

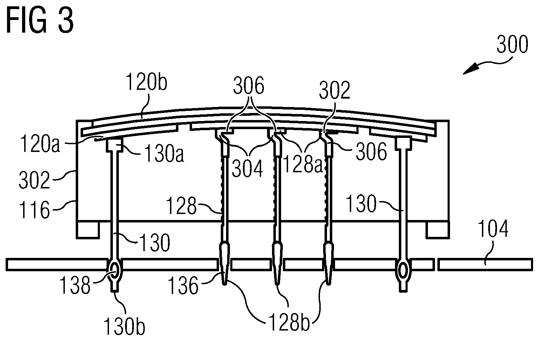

Figure 3 shows a further electronic system 300 comprising a semiconductor module 302 mounted on the PCB 104. The semiconductor module 302 may include some or all features of the semiconductor module 102 of Figures 1A-C and 2 and will thus only be described with respect to the differences. Wherein the contact pins 128, 130 in the previous embodiment have been described as comprising different locking features 134, 138, e.g. solid or hollow bulge, the contact pins 128, 130 may alternatively or in addition have different first ends 128a, 130a. As illustrated in Figure 3, the first end 128a of the first contact pin 128 has a base 306 which is mounted onto the first surface 120a of the substrate 120. The base 306 may be directly welded on the first surface 102a of the substrate 120. The first contact pin 128 further comprises a spring element 304 between the first locking feature 136 and the base 306 of the first contact pin 128.

In the simplest case the spring element 304 may be realized by a single bend between the base 306 and the first section 132 of the first contact pin 128. The second contact pin 130 may simply have a rigid shaft between the first 130a and second end 130b. During pressing of the semiconductor module 302 into the PCB 104, the force F applied by the pressing tool would directly be transferred via the rigid second contact pin 130 to the second locking feature 138 and the second locking feature 138 would be inserted into the PCB 104. Meanwhile the spring element 304 of the first contact pin 128 would be compressed before the first locking feature 136 is inserted into the PCB 104. Accordingly, the effective force required from the outside to push the first contact pin 128 into the PCB 104 is higher than for the second contact pin 130, even if the shape of the locking features 136, 138 of the first 128 and second contact pin 130 would provide the same resistance being pushed into the PCB 104. Thus, when the first contact pin 128 is also pushed into the PCB 104, the second contact pin 130 is already pushed deeper inside the PCB 104. After lifting the upper part 106t of the pressing tool 106, the spring elements 304 would relax to its original shape by pushing the substrate 120 in the central region 102c away from the first outer surface 114a of the semiconductor module 302. Therefore, the substrate 120 acquires the outward bend as described in Figure 1C.

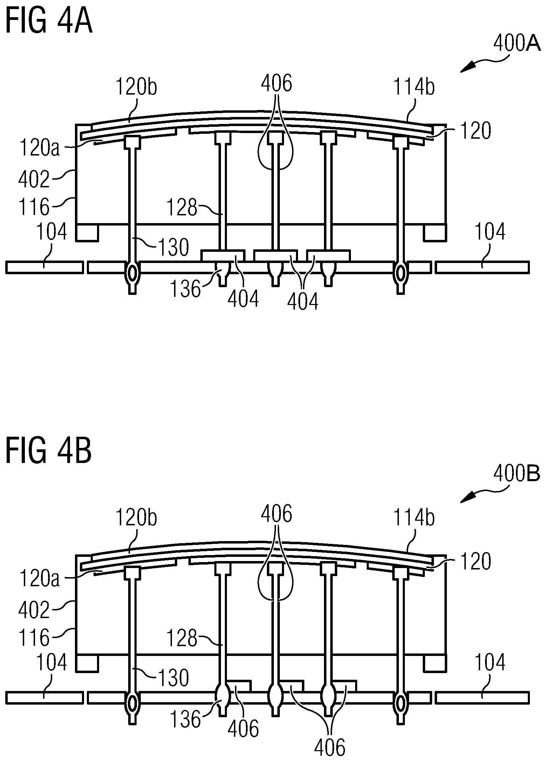

Figures 4A and 4B show a further electronic system 400A and 400B respectively comprising a semiconductor module 402 mounted on the PCB 104. The semiconductor module 402 may include some or all features of the semiconductor module 102 of Figures 1A-1C and 2 and will only be described with regard to the differences. Instead of delaying the first contact pin 128 to enter the PCB with respect to the second contact pin 130, it is also possible to prevent them from entering further into the PCB 104. This may be achieved by stopper elements 404, 406 provided at the first sections 132. As shown in Figure 4A, the stopper element 404 is located outside of the housing 116 and is just above the first locking feature 136. The stopper element 404 has a larger width than a width of the first section 132 of the first contact pin 128, wherein the width of the stopper element 404 and the width of the first section 132 of the first contact pin 128 are measured in a direction parallel to the first surface 120a of the substrate 120. Further, the stopper element 404 may be located up to 1 mm or higher away from the first outer surface 114a of the semiconductor module 402. The stopper 404 may be integrally formed with the first contact pin 128.

Alternatively, the stopper element 406 may have the same width as the first section 132 of the first contact pin 128 as shown in Figure 4B. However, the stopper element 406 may exceed the width of the first section 132 of the first contact pin 128 from a center of the shaft in at least one direction parallel to the first outer surface 114a of the semiconductor module 402.

When the first contact pin 128 is inserted into the PCB 104, as soon as the stopper element 404, 406 is in physical contact with the PCB 104, the first locking feature 136 cannot be inserted further into the PCB 104 even though the force F applied by the pressing tool 106 exceeds the first press-in force. The stopper element 404, 406 prevents the first contact pin 128 from penetrating deeper into the PCB 104 than the second contact pin 130, so that the substrate 120 is bend outwardly after removing the pressing tool, e.g. releasing the force F. Further, the stopper element 404, 406 maintains a defined distance between the PCB 104 and the first outer surface 114a of the semiconductor module 402. The location of the stopper element 404, 406 can be flexibly chosen according to the distance requirement between the PCB 104 and the semiconductor module 402.

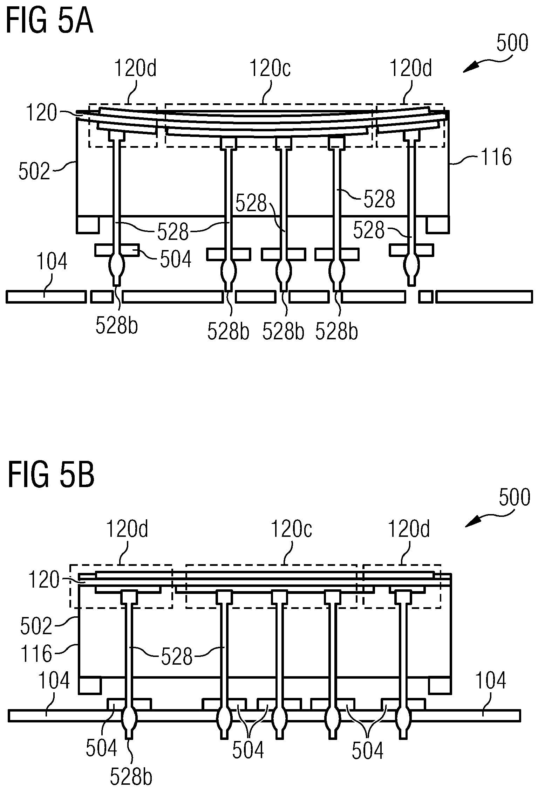

Figures 5A-5B show a further electronic system 500 comprising a semiconductor module 502 before and after mounting on the PCB 104 respectively. The semiconductor module 502 of Figure 5A may include some or all features of the semiconductor module 102, 402 of Figure 1A and 4 and will be discussed with regard to the differences only. As shown in Figure 5A, the semiconductor module 502 has a plurality of contact pins 528 and each contact pin 528 comprises a stopper element 504. The contact pins 528 are similar to the contact pin 128 of the semiconductor module 402 of Figure 4. Due to the inward bend in the substrate 120, the contact pins 528 in the central region 120c are closer to the PCB 104 as compared to the contact pins 528 in the peripheral region 120d. When the semiconductor module 502 is pressed into the PCB 104 by the force F, the contact pins 528 in the central region 120c penetrate the PCB 104 and are locked into the PCB 104 as they cannot penetrate the PCB 104 further due to the stopper elements 504. At this point the contact pins 528 in the peripheral region 120d are still not locked and when the semiconductor module 502 is further pressed into the PCB 104 by increasing the force F, the contact pins 528 in the peripheral region 120d penetrate the PCB 104 and are also locked into the PCB.

As the stopper element 504 of each contact pin 528 is at same height from the second end 528b of the respective contact pin 528, all the contact pins 528 have the same defined penetration depth into the PCB 104 after removing the pressing tool and thus releasing the force F. Thus, a distance between the substrate 120 and the PCB is the same in the central region and the peripheral region of the substrate i.e., the substrate 120 is flat as shown in Figure 5B. The first surface 120a or the second surface 120b of the substrate 120 is aligned in one plane. When a heat sink is connected to the second outer surface 114b of the semiconductor module, the heat sink and the semiconductor module 102 have a uniform contact area for heat transfer due to the flat substrate 120. This may dissipate the heat efficiently between the heat sink and the semiconductor module 502 and may require less thermal interface material as compared to the semiconductor module with the inward bend as shown in the initial state of Figure 5A.

The semiconductor die described in examples of this disclosure may, for example, be configured as power MISFETs (Metal Insulator Semiconductor Field Effect Transistors), power MOSFETs (Metal Oxide Semiconductor Field Effect Transistors), IGBTs (Insulated Gate Bipolar Transistors), JFETs (Junction Gate Field Effect Transistors), HEMTs (High Electron Mobility Transistors), power bipolar transistors or power diodes such as, e.g. PIN diodes or Schottky diodes.

The semiconductor die described in examples of this disclosure may be manufactured from specific semiconductor material such as, for example, Si, SiC, SiGe, GaAs, GaN, AlGaN, InGaAs, InAIAs, etc., and, furthermore, may contain inorganic and/or organic materials that are not semiconductors. The semiconductor die may be of different types and may be manufactured by different technologies.

The semiconductor module described in examples of this disclosure includes a substrate. The substrate may form a part of a structured metal layer such as, e.g. a leadframe. The substrate may include a sheet of ceramics coated with a metal layer, e.g. a metal bonded ceramics substrate. By way of example, the substrate may be a DCB (direct copper bonded) ceramics substrate.

The semiconductor module described in examples of this disclosure includes a contact pin. The contact pin may be made of any metal or metal alloy, e.g., copper or a copper alloy.

The substrate and the semiconductor die described in examples of this disclosure may be surrounded by a housing. The housing may comprise any plastic or non-conducting material and may form part of the outer surfaces of the semiconductor module, i.e. may at least partly define the shape of the semiconductor module.

The housing may be filled with a potting material to encapsulate the semiconductor die and partially the substrate. The potting material may comprise a thermoplastic material e.g., thermoplastic silicone, thermoplastic wax, or thermoplastic elastomer.

The semiconductor module described in examples of this disclosure includes a heat sink e.g., a metal sheet. The metal sheet may comprise a metal with high thermal and electrical conductivity for e.g. copper, aluminum, alloys of copper or alloys of aluminum.

The following examples pertain to further aspects of the disclosure:
Example 1 discloses a method for mounting a semiconductor module on a printed circuit board, PCB comprising;
   providing a semiconductor module comprising:
      a substrate having a first surface,
      a first contact pin having a first end and an opposing second end,
      a second contact pin having a first end and an opposing second end,
      wherein the respective first end of the first contact pin and the second contact pin is mounted over the first surface of the substrate,
   pressing the first contact pin and the second contact pin into respective through-holes of the PCB by applying a press-in force on the semiconductor module,
   inserting a first section of the first contact pin into the respective through-hole of the PCB with the press-in force in a first range,
   inserting a first section of the second contact pin into the respective through-hole of the PCB with a press-in force in a second range,
   wherein the first range of the press-in force is different than the second range of the press-in force, and
   wherein the first contact pin is provided in a central region of the substrate and the second contact pin is provided in a peripheral region of the substrate.
Example 2 discloses the method according to example 2, wherein the PCB is deformed in a direction of the force (F).
Example 3 discloses the method according to examples 2 to 3, wherein the first press-in force is higher than the second press-in force.
Example 4 discloses the method according to any of the preceding examples, wherein the first section of the first contact pin comprises a first locking feature and the first section of the second contact pin comprises a second locking feature different from the first locking feature.
Example 5 discloses the method according to any of the preceding examples, further comprising partially enclosing the first contact pin, the second contact pin and the substrate within a housing, wherein the first contact pin comprises a stopper outside of the housing, wherein a width of the stopper is equal to or larger than a width of the first section of the first contact pin, wherein the width of the stopper and the width of the first section of the first contact pin are measured in a plane parallel to the first surface of the substrate.
Example 6 discloses the method according to any of the preceding examples, wherein a length of the first contact pin is different than a length of the second contact pin.
Example 7 discloses a semiconductor module comprising:
   a substrate comprising a first surface,
   a first contact pin and a second pin,
   wherein a respective first end of the first contact pin and the second contact pin is mounted over the first surface of the substrate,
   a respective first section of the first contact pin and the second contact pin is configured to be connected to a printed circuit board, PCB,
   wherein the first section of the first contact pin is insertable to the PCB with a first press-in force,
   wherein the first section of the second contact pin is insertable to the PCB with a second press-in force,
   wherein the first press-in force is different than the second press-in force, and
   wherein the first contact pin is provided in a central region of the substrate and the second contact pin is provided in a peripheral region of the substrate.
Example 8 discloses the semiconductor module according to example 7, wherein the first press-in force is higher than the second press-in force.
Example 9 discloses the semiconductor module according to examples 7 to 8, wherein the first section of the first contact pin comprises a first locking feature and the first section of the second contact pin comprises a second locking feature different from the first locking feature.
Example 10 discloses the semiconductor module according to examples 7 to 9, wherein from the first contact pin and second contact pin only the first contact pin comprises a spring portion.
Example 11 discloses the semiconductor module according to examples 7 to 10, further comprises a housing partially enclosing the first contact pin, the second contact pin and the substrate, and wherein the first contact pin comprises a stopper outside of the housing, wherein a width of the stopper is equal to or larger than a width of the first section of the first contact pin, wherein the width of the stopper and the width of the first section of the first contact pin are measured in a plane parallel to the first surface of the substrate.
Example 12 discloses the semiconductor module according to examples 7 to 11, wherein a length of the first contact pin is different than a length of the second contact pin.
Example 13 discloses a semiconductor module comprising:
   a substrate having a first surface,
   a first contact pin having a first end and a first section,
   a housing partially enclosing the substrate and the first contact pin,
   wherein the first end of the first contact pin is mounted over the first surface of the substrate,
   wherein the first section of the first contact pin is configured to be connected to a printed circuit board, PCB,
   wherein the first contact pin comprises a stopper outside of the housing and
      wherein a width of the stopper is equal to or larger than a width of the first section of the first contact pin, and
   wherein the width of the stopper and the width of the first section of the first contact pin are measured in a plane parallel to the first surface of the substrate.

## Claims

1. A method for mounting a semiconductor module (102, 302, 402) on a printed circuit board, PCB (104), the method comprising;
providing (100) a semiconductor module (102, 302, 402) comprising:
a substrate (120) having a first surface (120a),
a first contact pin (128) having a first end (128a) and an opposing second end (128b),
a second contact pin (130) having a first end (130a) and an opposing second end (130b),
wherein the respective first end (128a, 130a) of the first contact pin (128) and the second contact pin (130) is mounted over the first surface (120a) of the substrate (120),
pressing (150) the first contact pin (128) and the second contact pin (130) into respective through-holes (140) of the PCB (104) by applying a force (F) on the semiconductor module (102, 302, 402),
inserting a first section (132) of the first contact pin (128) into the respective through-hole (140) of the PCB (104) with a first press-in force,
inserting a first section (134) of the second contact pin (130) into the respective through-hole (140) of the PCB (104) with a second press-in force,
wherein the first press-in force is different than the second press-in force, and
wherein the first contact pin (128) is provided in a central region (120c) of the substrate (120) and the second contact pin (130) is provided in a peripheral region (120d) of the substrate (120).

2. The method according to claim 2, wherein the PCB (104) is partially deformed in a direction of the force (F).

3. The method according to claims 2 to 3, wherein the first press-in force is higher than the second press-in force.

4. The method according to any of the preceding claims, wherein the first section (132) of the first contact pin (128) comprises a first locking feature (136) and the first section (134) of the second contact pin (130) comprises a second locking feature (138) different from the first locking feature (136).

5. The method according to any of the preceding claims, further comprising at least partially enclosing the first contact pin (128), the second contact pin (130) and the substrate (120) within a housing (116), wherein the first contact pin (128) comprises a stopper (404, 406) outside of the housing (116), wherein a width of the stopper (404, 406) is equal to or larger than a width of the first section (132) of the first contact pin (128), wherein the width of the stopper (404, 406) and the width of the first section (132) of the first contact pin (128) are measured in a plane parallel to the first surface (120a) of the substrate (120).

6. The method according to any of the preceding claims, wherein a length of the first contact pin (128) is different than a length of the second contact pin (130).

7. A semiconductor module (102, 302, 402) comprising:
a substrate (120) comprising a first surface (120a),
a first contact pin (128) and a second pin (130),
wherein a respective first end (128a, 130a) of the first contact pin (128) and the second contact pin (130) is mounted over the first surface (120a) of the substrate (120),
a respective first section (132, 134) of the first contact pin (128) and the second contact pin (130) configured to be connected to a printed circuit board, PCB (104),
wherein the first section (132) of the first contact pin (128) is insertable into the PCB (104) with a first press-in force,
wherein the first section (134) of the second contact pin (130) is insertable into the PCB (104) with a second press-in force different than the first press-in force, and
wherein the first contact pin (128) is provided in a central region (120c) of the substrate (120) and the second contact pin (130) is provided in a peripheral region (120d) of the substrate (120).

8. The semiconductor module (102, 302, 402) according to claim 7, wherein the first press-in force is higher than the second press-in force.

9. The semiconductor module (102, 302, 402) according to claims 7 to 8, wherein the first section (132) of the first contact pin (128) comprises a first locking feature (136) and the first section (134) of the second contact pin (130) comprises a second locking feature (136) different from the first locking feature (136).

10. The semiconductor module (102, 302, 402) according to claims 7 to 9, wherein from the first contact pin (128) and second contact pin (130) only the first contact pin (128) comprises a spring portion.

11. The semiconductor module (402) according to claims 7 to 10, further comprises a housing (116) partially enclosing the first contact pin (128), the second contact pin (130)and the substrate (120), and wherein the first contact pin (128) comprises a stopper (404, 406) outside of the housing (116), wherein a width of the stopper (404, 406) is equal to or larger than a width of the first section (132) of the first contact pin (128), wherein the width of the stopper (404, 406) and the width of the first section (132) of the first contact pin (128) are measured in a plane parallel to the first surface (120a) of the substrate (120).

12. The semiconductor module (102, 302, 402) according to claims 7 to 11, wherein a length of the first contact pin (128) is different than a length of the second contact pin (130).

13. A semiconductor module (502) comprising:
a substrate (120) having a first surface (120a),
a first contact pin (128) having a first end (128a) and a first section (132),
a housing (116) partially enclosing the substrate (120) and the first contact pin (128),
wherein the first end (128a) of the first contact pin (128) is mounted over the first surface (120a) of the substrate (120),
wherein the first section (132) of the first contact pin (128) is configured to be connected to a printed circuit board, PCB,
wherein the first contact pin (128) comprises a stopper (504) outside of the housing (116) and wherein a width of the stopper (504) is larger than a width of the first section (132) of the first contact pin (128), and
wherein the width of the stopper (504) and the width of the first section (132) of the first contact pin (128) are measured in a plane parallel to the first surface (128a) of the substrate (128).
